# EUROPÄISCHE PATENTSCHRIFT

(11) **EP 3 139 719 B1**
(45) Veröffentlichungstag und Bekanntmachung des Hinweises auf die Patenterteilung: **26.02.2020**
(21) Anmeldenummer: 15184145.9
(22) Anmeldetag: 07.09.2015
(51) Int. Cl.: H05K 9/00, H02G 3/06

(54) **KONTAKTIERUNGSVORRICHTUNG FÜR KABELDURCHFÜHRUNGEN UND KABELDURCHFÜHRUNG**
CONTACTING DEVICE FOR CABLE FEEDTHROUGH AND CABLE FEEDTHROUGH
DISPOSITIF DE MISE EN CONTACT POUR PASSE-CABLES ET PASSE-CABLE

(43) Veröffentlichungstag der Anmeldung: 08.03.2017
(73) Patentinhaber: Lapp Engineering & Co., 6330 Cham (CH)
(72) Erfinder: MÜLLER, Daniel, 71686 Remseck (DE); DROTLEFF, Rolf, 75932 Deckenpfron (DE); BAUER, Andreas, 70193 Stuttgart (DE)
(74) Vertreter: Rutz & Partner

(56) Entgegenhaltungen:
- EP-A1- 0 991 309
- WO-A1-00/59998
- DE-U1- 29 620 288
- JP-A- 2003 224 389
- US-A1- 2008 073 102

## Beschreibung

Die Erfindung betrifft eine Kontaktierungsvorrichtung für Kabeldurchführungen und eine Kabeldurchführung mit einer solchen Kontaktierungsvorrichtung.

Oft umfassen Kabeldurchführungen eine Halterung, mittels der die durchgeführten Kabel mechanisch fixiert werden, so dass sie beim Auftreten mechanischer Belastungen nicht von den Anschlusskontakten getrennt werden. Zudem werden die Öffnungen, durch die die Kabel durchgeführt werden, oft durch die Kabeldurchführung abgedichtet, so dass keine Flüssigkeiten und/oder Gase durch die Trennwand hindurch treten können. Derartige Kabeldurchführungen sind aus der EP2249448A2 sowie der EP2866322A1 bekannt. Diese Kabeldurchführungen umfassen Dichtmodule, die die Kabel umschliessen und aus nicht leitfähigen Materialien, z.B. Kunststoff oder Gel, gefertigt sind. Es besteht somit keine elektrische Verbindung zwischen den durchgeführten Kabeln oder Kabelabschirmungen und der Trennwand. Eine durchgehende Kabelabschirmung gegen elektromagnetische Strahlung ist somit nicht gewährleistet. Aus der JP2003224389A ist ein Kabeleinführungsmodul zur schnellen Einführung von Kabeln durch eine Wand bekannt. Das Kabeleinführungsmodul umfasst bürstenartige Borsten zur elektromagnetischen Abschirmung.

Aus der US 2008/073102 A1 ist eine Durchführung für ein einzelnes Kabel durch eine Wand bekannt. Die Durchführung weist ein Schirmkontaktelement auf.

Der vorliegenden Erfindung liegt somit die Aufgabe zugrunde, eine Kontaktierungsvorrichtung für Kabeldurchführungen sowie eine verbesserte Kabeldurchführung zu schaffen, die mit einer solchen Kontaktierungsvorrichtung versehen ist.

Insbesondere sind eine Kontaktierungsvorrichtung und eine Kabeldurchführung zu schaffen, bei der eine durchgängige Kabelabschirmung gegen elektrische und/oder magnetische Felder der durchgeführten Kabel erreicht wird.

Die erfindungsgemässe Kontaktierungsvorrichtung soll mit bekannten Kabeldurchführungen koppelbar sein, sodass durch die Kombination von erfindungsgemässen Kontaktierungsvorrichtungen und bekannten Kabeldurchführungen verbesserte Kabeldurchführungen geschaffen werden.

Die Kontaktierungsvorrichtung soll einfach aufgebaut sein und einfach montiert werden können. Weiterhin soll die erfindungsgemässe Kontaktierungsvorrichtung durchgeführte Kabel unabhängig von ihrem Kabeldurchmesser zuverlässig kontaktieren.

Die Kontaktierung der durchgeführten Kabel soll ohne zusätzlichen Montageaufwand erfolgen.

Erfindungsgemässe Kabeldurchführungen sollen Kabel mechanisch halten und/oder abdichten und zuverlässig elektrisch kontaktieren.

Diese Aufgabe wird mit einer Kontaktierungsvorrichtung und einer Kabeldurchführung gelöst, welche die in Anspruch 1 bzw. 11 angegebenen Merkmale aufweisen. Vorteilhafte Ausgestaltungen der Erfindung sind in weiteren Ansprüchen angegeben.

Die Kontaktierungsvorrichtung, die für eine Kabeldurchführung vorgesehen ist, die in elektrischen Vorrichtungen, wie Schaltschränken, zur Durchführung von Kabel, insbesondere abgeschirmter Kabel dient, umfasst eine mit einer Wandöffnung versehene Wand und metallene Ableitelemente, die elektrisch leitend einerseits mit der Kabelabschirmung wenigstens eines durch die Wandöffnung hindurch durchgeführten Kabels und andererseits über wenigstens eine Befestigungsvorrichtung mit der Wand und vorzugsweise Massepotential einer elektrischen Vorrichtung verbunden oder verbindbar ist.

Erfindungsgemäss ist die wenigstens eine Befestigungsvorrichtung als metallener Kammrücken ausgebildet, an dem die Ableitelemente, die drahtförmig in die Wandöffnung hineinragen, als Kammfinger befestigt sind.

Die erfindungsgemässe Kabeldurchführung umfasst vorzugsweise eine dem mechanischen Halten und/oder der Abdichtung von durchgeführten Kabel dienende erste Kabeldurchführung, die durch Verbindungsmittel vorzugsweise parallel zu den Ableitelementen ausgerichtet mit der Kontaktierungsvorrichtung verbunden ist, welche als zweite Kabeldurchführung dient.

Die erfindungsgemässe Kontaktierungsvorrichtung, die der Durchführung von Kabeln, insbesondere von abgeschirmten Kabeln, durch eine Wandöffnung, z.B. in der Wand eines Schaltschranks, einer elektrischen Maschine oder eines Roboters dient, umfasst zumindest eine Befestigungsvorrichtung, an welcher Ableitelemente derart angebracht sind, dass zwischen den Ableitelementen und der Befestigungsvorrichtung eine elektrisch leitende Verbindung resultiert. Die Arbeitselemente sind vorzugsweise derart ausgestaltet, dass der Kontaktwiderstand dieser elektrisch leitenden Verbindung kleiner als 1 Ω, vorzugsweise kleiner als 0.1 Ω oder vernachlässigbar ist. Die Befestigungsvorrichtung ist derart mit der Wand, in der sich die Wandöffnung befindet, verbindbar, dass eine elektrisch leitende Verbindung zwischen der Wand oder elektrisch leitenden Elementen der Wand und der Befestigungsvorrichtung resultiert. Der Kontaktwiderstand dieser elektrisch leitenden Verbindung ist in einer weiteren bevorzugten Ausgestaltung kleiner als 1Ω. In einer besonders bevorzugten Ausgestaltung ist der Gesamtwiderstand zwischen der Wand (bzw. der elektrischen leitenden Elementen der Wand) und den Ableitelementen kleiner als 1Ω, vorzugsweise kleiner als 0.1 Ω oder vernachlässigbar. Die Ableitelemente sind mit der Kabelabschirmung der durchgeführten Kabel verbindbar, so dass eine durchgehend elektrisch leitfähige Verbindung zwischen der Kabelabschirmung und der Wand (bzw. der elektrisch leitenden Elemente der Wand) entsteht. Durch die durchgehend elektrisch leitfähige Verbindung wird sichergestellt, dass eine durchgehende Kabelabschirmung gegen elektromagnetische Strahlung besteht.

Die Befestigungsvorrichtung ist als metallener Kammrücken ausgebildet, an dem die drahtförmigen Ableitelemente, die in die Wandöffnung hineinragen, befestigt sind. In einer bevorzugten Ausführungsform ist eine Vielzahl an Ableitelementen an der Befestigungsvorrichtung angebracht, wobei die Ableitelemente weitestgehend regelmässig entlang der Befestigungsvorrichtung verteilt sind.

In einer bevorzugten Ausgestaltung ist wenigstens eine Befestigungsvorrichtung am Rand der Wandöffnung befestigt und einseitig mit Ableitelementen verbunden. Die Ableitelemente sind so angeordnet, dass sie die Wandöffnung zumindest teilweise bedecken.

In einer weiteren bevorzugten Ausgestaltung ist die Befestigungsvorrichtung beidseitig mit Ableitelementen verbunden. Die Befestigungsvorrichtung wird bei dieser Ausführungsform innerhalb der Wandöffnung angeordnet, so dass die Ableitelemente die durch die Befestigungsvorrichtung in zwei Öffnungen unterteilte Wandöffnung bedecken.

Wandöffnungen z.B. in Wänden von Schaltschränken, die der Durchführung mehrerer Kabel dienen, sind oftmals rechteckig ausgeführt. In einer weiteren erfindungsgemässen Ausgestaltung umfasst die Kabeldurchführung mehrere Befestigungsvorrichtungen, bevorzugt zwei oder vier, welche entlang der Rechteckseiten angebracht werden, so dass die Ableitelemente senkrecht zur jeweiligen Rechteckseite in die Wandöffnung hineinragen.

Die Verbindung der Ableitelemente mit der Befestigungsvorrichtung ist derart vorgesehen, dass eine gute elektrische Leitung zwischen diesen beiden Komponenten vorliegt. Vorzugsweise wird dies durch eine Klemmung der Ableitelemente in einer an der Befestigungsvorrichtung angebrachten Klemmvorrichtung erreicht. Die Ableitelemente werden hierzu in der noch nicht aktivierten Klemmvorrichtung platziert und durch Betätigung der Klemmvorrichtung in dieser mechanisch fixiert. In einer weiteren erfindungsgemässen Ausführungsform werden die Ableitelemente durch eine Lötverbindung oder eine Schweissverbindung mit der Befestigungsvorrichtung verbunden.

Erfindungsgemäss umfasst die Kabeldurchführung zwei Befestigungsvorrichtungen, die auf gegenüberliegenden Seiten der Wandöffnung angebracht sind. Die von den beiden Befestigungsvorrichtungen gehaltenen Ableitelemente sind dabei gegeneinander ausgerichtet. Weiterhin ist die Länge der Ableitelemente so gewählt, dass die Wandöffnung durch die Ableitelemente zumindest annähernd verschlossen wird und dass sich die Ableitelemente im Bereich der Mitte der Wandöffnung überlappen.

In einer weiteren erfindungsgemässen Ausgestaltung umfasst die Kabeldurchführung zwei Befestigungsvorrichtungen, die mit jeweils einem Endstück der Ableitelemente verbunden sind. Die Länge der Ableitelemente ist vorzugsweise so gewählt, dass diese länger sind als der Abstand zwischen den beiden Befestigungsvorrichtungen im montierten Zustand. Dadurch sind die Ableitelemente nicht starr zwischen den beiden Befestigungsvorrichtungen gespannt, sondern weisen eine Flexibilität auf, die die Durchführung von Kabeln durch das durch die Ableitelemente aufgespannte Gitter ermöglicht. Vorzugsweise sind die Ableitelemente als drahtförmige Metalllitzen ausgeführt. Vorzugsweise sind 10 bis 100 Ableitelemente pro mm Länge an der Befestigungsvorrichtung angebracht. Die Ableitelemente weisen eine hohe elektrische Leitfähigkeit auf und sind dicht nebeneinander angeordnet. Vorteilhaft können die Ableitelemente aus Kupfer, Messing, beschichteten Metalldrähten, leitfähigem Kunststoff, Stahl oder Kombinationen davon gefertigt werden. Die drahtförmigen Ableitelemente weisen bevorzugt einen Durchmesser von 0.025mm bis 0.25mm, weiter bevorzugt 0.05mm bis 0.15mm, auf. Vorzugsweise ist der Durchmesser so auf das verwendete Material und dessen mechanische Eigenschaften abgestimmt, dass die Ableitelemente einerseits eine hohe Flexibilität aufweisen - um sich der Form der durchgeführten Kabel anzupassen - und andererseits über eine ausreichende Steifigkeit verfügen um eine gute elektrische Kontaktierung der Kabelabschirmung sicherzustellen.

In einer weiteren bevorzugten erfindungsgemässen Ausgestaltung sind die Ableitelemente elastisch ausgeführt. Besonders gute Kontaktierung werden mit einer plattenförmigen, kurvenförmigen oder wellenförmigen Ausbildung der Arbeitselemente erzielt.

In einer weiteren bevorzugten erfindungsgemässen Ausgestaltung sind die Ableitelemente U-förmig ausgeführt, sodass jedes Arbeitselement zwei Kammfinger zur Verfügung stellt. Vorzugsweise sind die beiden Schenkel der Ableitelemente zumindest annähernd parallel zueinander ausgerichtet. Bei dieser Ausgestaltung entstehen durch das Netz der Ableitelemente zwei zueinander parallele Ebenen, welche beide elektrisch leitfähig sind. Dadurch halbieren sich die Kontaktwiderstände und die Schirmdämpfung des Systems wird deutlich verbessert.

Die Befestigungsvorrichtung, an der die Ableitelemente angebracht sind, ist aus einem elektrisch leitenden Material, vorzugsweise zumindest teilweise aus Aluminium gefertigt. Die Befestigungsvorrichtung wird derart mit der Wand der Kontaktierungsvorrichtung verbunden, dass eine elektrisch leitendende Verbindung resultiert. Vorzugsweise sind an der Befestigungsvorrichtung Gewindebohrungen und/oder Bohrungen für Schrauben angebracht, mit denen die Befestigungsvorrichtung an die Wand geschraubt wird. In einer weiteren bevorzugten Ausgestaltung sind an der Befestigungsvorrichtung Schnellverriegelungselemente, wie Schnappelemente, angebracht, die durch die Wandöffnung durchgeführt werden können und die Wandöffnung hintergreifen, so dass die Befestigungsvorrichtung mechanisch stabil in der Wandöffnung gehalten wird.

Nachfolgend wird die Erfindung anhand von Zeichnungen näher erläutert. Dabei zeigt:
- Fig. 1: einen Ausschnitt einer erfindungsgemässen Kontaktierungsvorrichtung 1 mit von einer Befestigungsvorrichtung 4 gehaltenen Ableitelementen 3, durch die ein Kabel 9 derart durchgeführt ist, dass dessen freigelegte Kabelabschirmung 91 mit Erde oder Masse 2 eines elektrischen Geräts verbindbar ist;
- Fig. 2a: eines der U-förmigen Ableitelemente 3 aus Fig. 1;
- Fig. 2b: in einer Schnittansicht zwei Gruppen von Ableitelementen 3, die einander gegenüberliegen und sich überlappen und je in einer Klemmvorrichtung 41 gehalten sind;
- Fig. 2c: in einer Schnittansicht zwei weitere Gruppen von Ableitelementen 3, die einander gegenüberliegen und sich überlappen und je in einer Klemmvorrichtung 41 gehalten sind;
- Fig. 3a: eine erfindungsgemässe Kabeldurchführung 10 mit einer ersten Kabeldurchführung 6, die dem Halten und Abdichten der durchgeführten Kabel 9 dient und einer damit verbundenen Kontaktierungsvorrichtung 1 gemäss Fig. 1, die eine kontaktierende zweite Kabeldurchführung bildet und mittels Schrauben 7 mit der ersten Kabeldurchführung 6 verbunden ist;
- Fig. 3b: die Kabeldurchführung 10 von Fig. 3a mit der ersten Kabeldurchführung 6, die entlang der Linie A-A aus Fig. 3a geschnitten ist, und der Kontaktierungsvorrichtung 1 von Fig. 1, die der kontaktierten Durchführung der Kabel 9 dient;
- Fig. 4: die Kabeldurchführung 10 von Fig. 3b mit Blick auf die Kontaktierungsvorrichtung 1, die durch Schrauben 7 und Schraubenmuttern 71 mit der ersten Kabeldurchführung 6 verbunden ist.

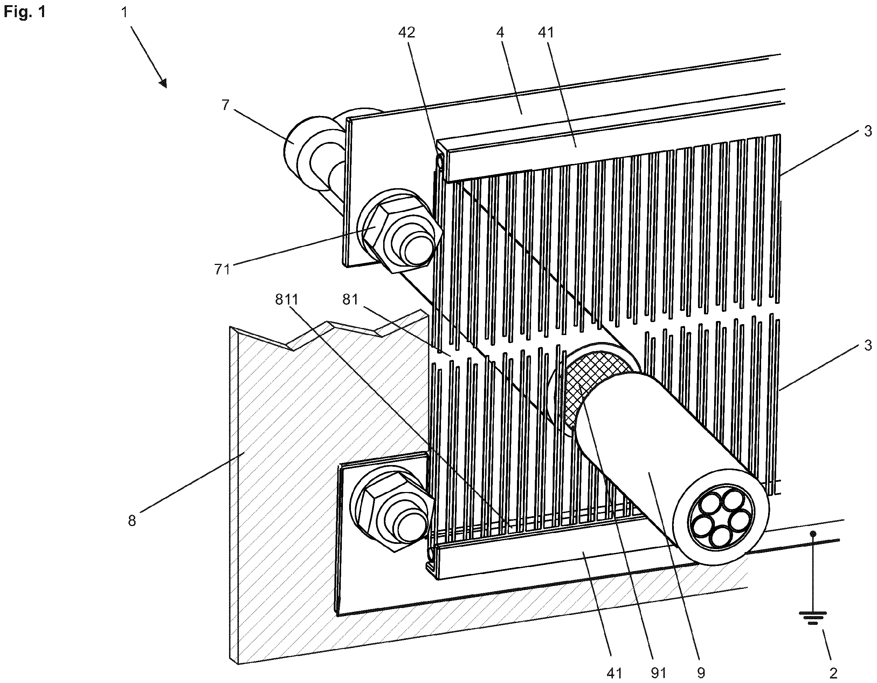

Fig. 1 zeigt einen Ausschnitt einer erfindungsgemässen Kontaktierungsvorrichtung 1, die der Durchführung und Kontaktierung von Kabel 9 dient, das mit einer Kabelabschirmung 91 versehen ist. Die Kontaktierungsvorrichtung 1 umfasst zwei Gruppen von Ableitelementen 3, welche an einer Befestigungsvorrichtung 4 angebracht sind. Die Befestigungsvorrichtung 4 ist durch Verbindungsmittel, wie Schrauben 7 und Schraubenmuttern 71, mit einer Wand 8 verbunden, die eine Wandöffnung 81 aufweist. Die Wandöffnung 81 wird durch die Kontaktierungsvorrichtung 1 zumindest teilweise derart verschlossen, dass Kabel 9, die durch die Kabeldurchführung 1 hindurch geführt werden, die Ableitelemente 3 seitlich verdrängen bzw. zur Seite biegen. Im Bereich der Wandöffnung 81 ist das Kabel 9 ringförmig abgemantelt, so dass die Kabelabschirmung 91 freigelegt ist. Der abgemantelte Kabelabschnitt ist derart positioniert, dass er auf der Höhe der Ableitelemente 3 liegt, die gegen die Kabelabschirmung 91 drücken und diese kontaktieren, wodurch die Kabelabschirmung 91 über die Ableitelemente 3 elektrisch leitend mit der Befestigungsvorrichtung 4 verbunden wird, die an Masse 2 liegt. Die Befestigungsvorrichtungen 4 umfasst zwei Klemmvorrichtungen 41, welche U-förmige Ableitelemente 3 rückseitig halten und an stabförmigen Rückhaltelementen 42 festklemmen. Die beiden Klemmvorrichtungen 41 sind an einander gegenüberliegenden Rechteckseiten 811 der Wandöffnung 81 derart angeordnet, dass die beiden Gruppen von Ableitelementen 3 einander zugewandt sind.

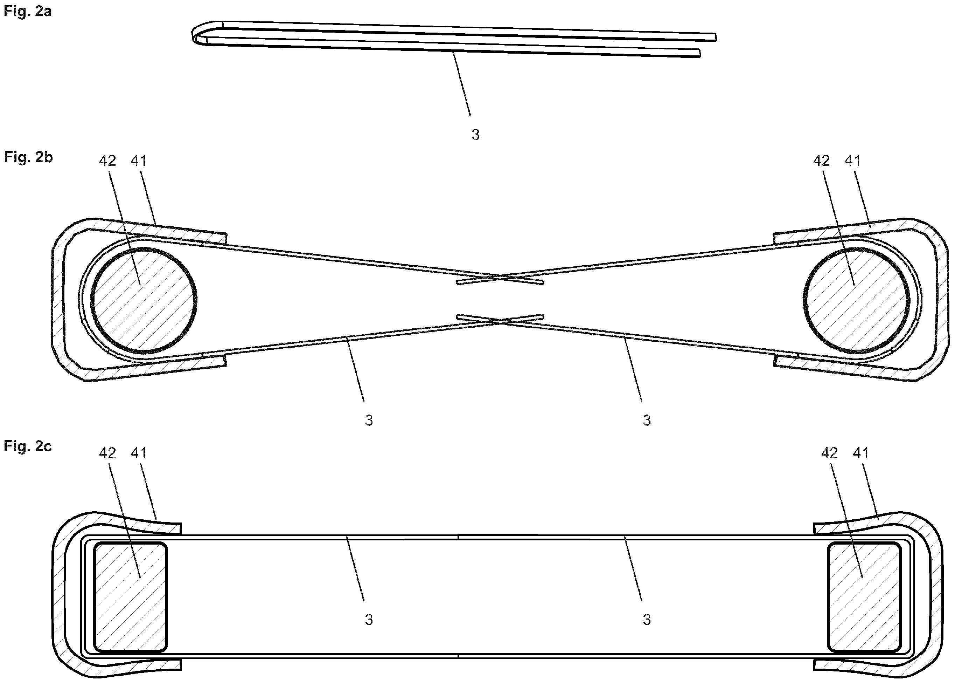

Fig. 2a zeigt eine bevorzugte Ausgestaltung eines erfindungsgemässen Ableitelements 3. Das Ableitelement 3 weist eine langgezogene U-Form auf.

Fig. 2b zeigt eine bevorzugte Ausgestaltung zweier sich gegenüberliegender Klemmvorrichtungen 41, in welchen Ableitelemente 3 gehalten sind. Die Ableitelemente 3 werden durch Rückhaltelemente 42, welche vorzugsweise in die Klemmvorrichtung 41 eingepresst werden, mechanisch fixiert und in Position gehalten. Die Rückhaltelemente 42 sind stabförmig ausgebildet und weisen einen kreisförmigen Querschnitt auf. Dadurch, dass die einander zugewandten Ableitelemente 3 sich überlappen, entsteht eine elektrisch leitende Verbindung zwischen den beiden Klemmvorrichtungen 41 und somit eine optimale und durchgehende Kabelabschirmung gegen elektromagnetische Felder. Diese Kabelabschirmung zeichnet sich, sowohl mit als auch ohne durchgeführtes Kabel 9, durch eine hohe Schirmdämpfung aus.

Fig. 2c zeigt eine weitere erfindungsgemässe Ausgestaltung eines Ableitelements 3, welches in einer Klemmvorrichtung 41 gehalten ist. Das Ableitelement 3 weist eine U-förmige Form auf, wobei die beiden Schenkel des U vorzugsweise beinahe parallel zueinander aus der Klemmvorrichtung 41 hinaus ragen. Um die Richtung der beiden Schenkel des Ableitelements 3 ausrichten zu können sind die Seiten der Rückhalteelemente 42 parallel zueinander ausgeführt. In der gezeigten Ausgestaltung sind die Rückhalteelemente 42 dazu mit einem rechteckigen Querschnitt versehen.

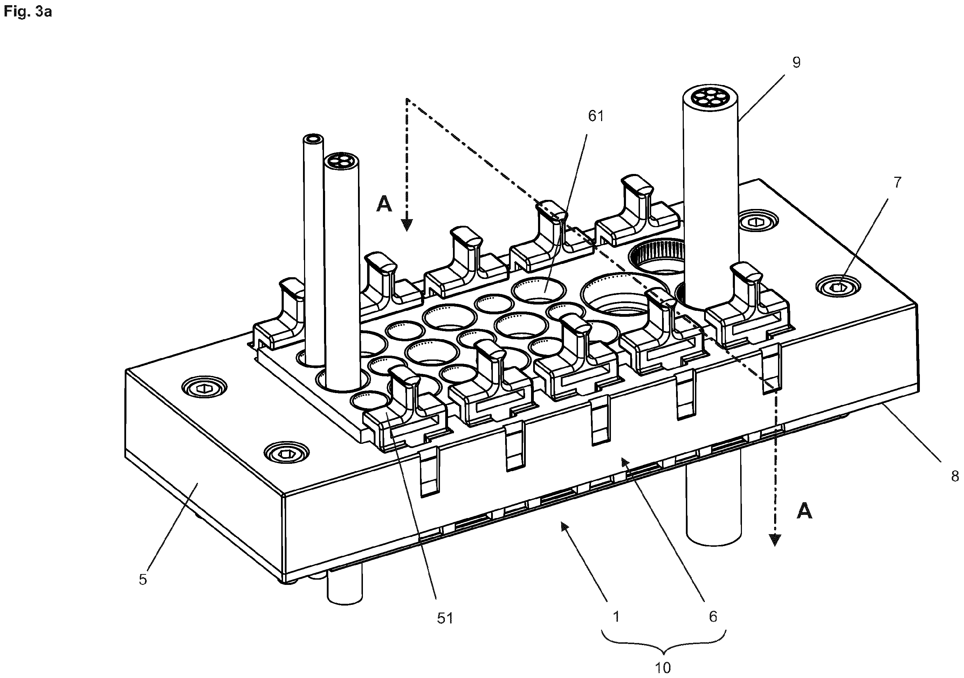

Fig. 3a zeigt eine erfindungsgemässe Kabeldurchführung 10 mit einer ersten Kabeldurchführung 6, die dem Halten und Abdichten der durchgeführten Kabel 9 dient und einer damit verbundenen Kontaktierungsvorrichtung 1 gemäss Fig. 1, die eine kontaktierende zweite Kabeldurchführung bildet und die mittels Schrauben 7 mit der ersten Kabeldurchführung 6 verbunden ist. Die erste Kabeldurchführung 6, die aus dem Stand der Technik bekannt ist, ist durch Haltevorrichtungen 51 in einem Halterahmen 5 gehalten. Der Halterahmen 5 ist durch Schrauben 7 mit der Wand 8 und der Kontaktierungsvorrichtung 1 Fig. 1 verbunden. Kabel 9 sind durch Öffnungen 61 in der Mehrfachkabeldurchführung 6 durchgeführt und werden darin mechanisch gehalten und sind darin vorzugsweise dicht umschlossen, sodass keine Flüssigkeit durch die erfindungsgemässe Kabeldurchführung 10 hindurch treten kann.

Die erfindungsgemässe Kontaktierungsvorrichtung 1 kann daher z.B. durch Schrauben 7 mit bestehenden Kabeldurchführungen 6 verbunden werden, wodurch erfindungsgemässe Kabeldurchführungen bzw. Kabeldurchführungsvorrichtungen 10 resultieren, durch die durchgeführte Kabel 9 mechanisch halten, elektrisch kontaktieren und vorzugsweise dicht umschliessen.

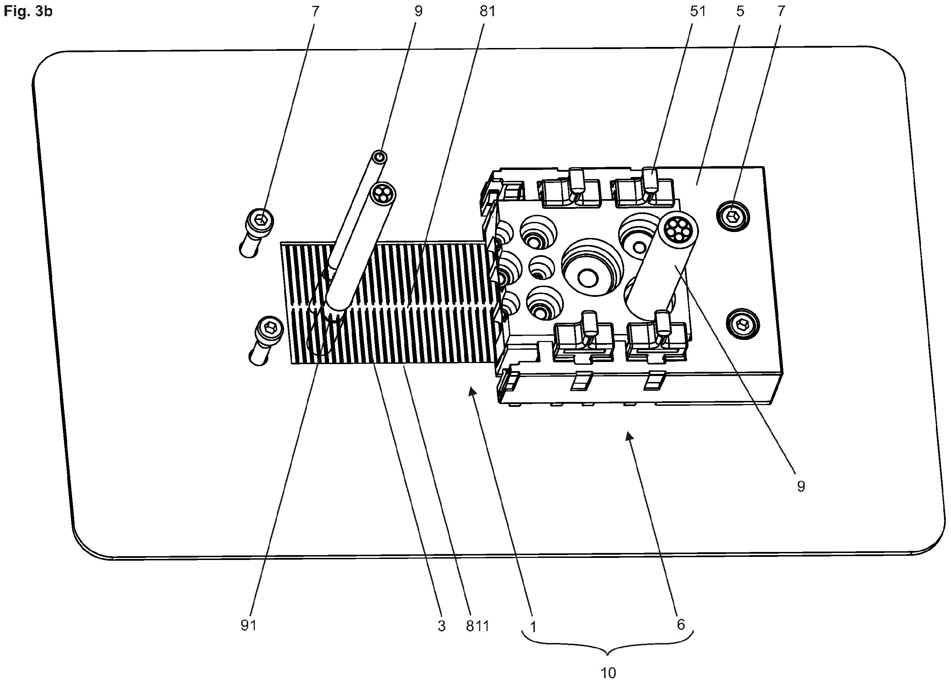

Fig. 3b zeigt einen Ausschnitt einer Wand 8 (z.B. eines Schaltschranks oder eines elektrischen Geräts) mit einer Wandöffnung 81, an der die Kabeldurchführung 10 von Fig. 3a montiert ist. Die konventionelle erste Kabeldurchführung 6, die entlang der Linie A-A aus Fig. 3a geschnitten ist, ist auf einer Seite der Wand 8 und die Kontaktierungsvorrichtung 1 von Fig. 1 auf der anderen Seite der Wand 8 montiert.

Durch die erfindungsgemässe Kontaktierungsvorrichtung 1 wird die Wandöffnung 81 mit elektrisch leitfähigen Ableitelementen 3 verschlossen, wodurch die durch die Wandöffnung 81 unterbrochene Abschirmung der Wand 8 gegen elektromagnetische Strahlung wiederhergestellt wird. Trotz der Wandöffnung 81 gewährleistet die Wand 8 somit eine optimale Abschirmung oder Isolation gegen elektromagnetische Wellen.

Die Ableitelemente 3 sind, wie in Fig. 1 gezeigt, von einer Befestigungsvorrichtung 4 mittels zwei Klemmvorrichtungen 41 gehalten, welche entlang von einander gegenüberliegenden Rechteckseiten 811 der Wandöffnung 81 ausgerichtet sind. Wie in den Figuren 1 und 3b gezeigt, können Kabel 9 allein durch eine erfindungsgemässe Kontaktierungsvorrichtung 1 oder sequentiell durch eine erste Kabeldurchführung 6 und danach durch eine erfindungsgemässe Kontaktierungsvorrichtung 1 hindurch geführt werden, die aus zweite Kabeldurchführung dient.

Falls die durchgeführten Kabel 9 gegenüber der Wand 8 mechanisch fixiert sein sollen, wird vorzugsweise eine erste Kabeldurchführung 6 eingesetzt, die in der gezeigten oder auch in einer anderen Ausgestaltung vorliegen kann. Die erste Kabeldurchführung 6 kann auch eine Zugentlastung und/oder eine Abdichtung der Kabel 9 sicherstellen.

Bei Anwendungen, bei keine mechanische Fixierung oder Abdichtung der Kabel 9 erforderlich ist, sondern ausschliesslich eine durchgehende Kabelabschirmung gegen elektromagnetische Strahlung sichergestellt werden muss, kann die als Kabeldurchführung dienende Kontaktierungsvorrichtung 1 alleine eingesetzt werden. Vorzugsweise werden eine erste Kabeldurchführung 6 und eine zweite Kabeldurchführung in Ausgestaltung der Kontaktierungsvorrichtung 1 als erfindungsgemässe Kabeldurchführung 10 in Kombination eingesetzt.

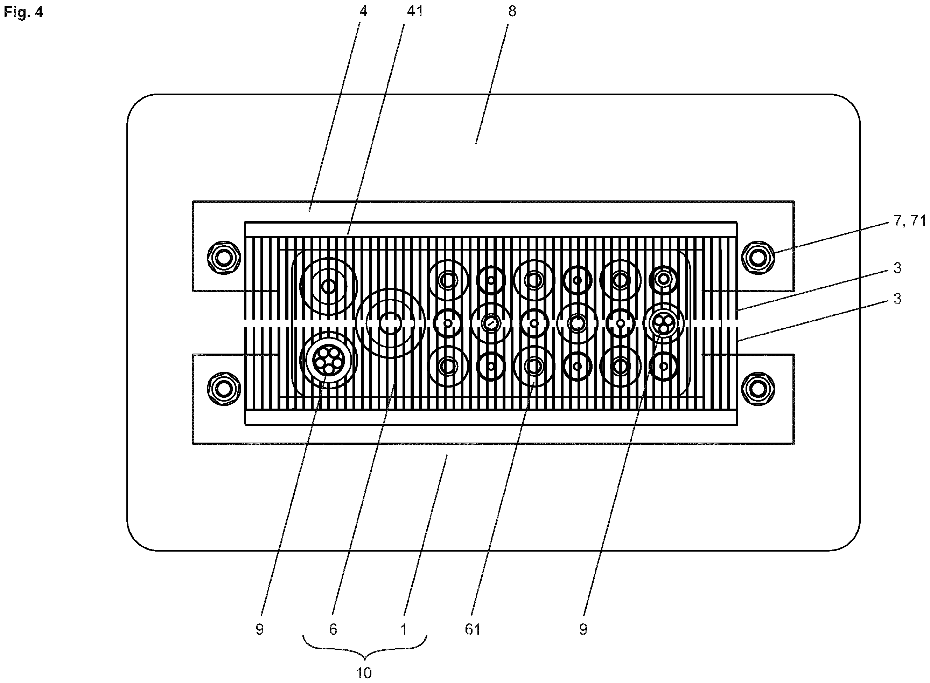

Fig. 4 zeigt die in der Wandöffnung 81 montierte Kabeldurchführung 10 von Fig. 3b mit Blick auf die Kontaktierungsvorrichtung 1, die durch Schrauben 7 und Schraubenmuttern 71 mit der ersten Kabeldurchführung 6 verbunden ist.

### Bezugszeichenliste

- 1: Kabeldurchführung
- 2: Masse
- 3: Ableitelemente
- 4: Befestigungsvorrichtung
- 41: Klemmvorrichtung
- 42: Rückhalteelement
- 5: Halterahmen
- 51: Haltevorrichtungen
- 6: Mehrfachkabeldurchführung
- 61: Öffnungen
- 7: Verbindungsmittel, Schrauben
- 71: Mutter
- 8: Wand
- 81: Wandöffnung
- 811: Rechteckseite
- 9: Kabel
- 91: Kabelabschirmung

## Patentansprüche

1. Kontaktierungsvorrichtung (1) für eine Kabeldurchführung, die in elektrischen Vorrichtungen, wie Schaltschränken, zur Durchführung von Kabel (9), insbesondere abgeschirmter Kabel, mit einer mit einer Wandöffnung (81) versehenen Wand (8) und metallenen Ableitelementen (3), die elektrisch leitend einerseits mit der Kabelabschirmung (91) wenigstens eines durch die Wandöffnung (81) hindurch durchgeführten Kabels (9) und andererseits über wenigstens eine Befestigungsvorrichtung (4), die als metallener Kammrücken ausgebildet ist, an dem die Ableitelemente (3), die drahtförmig in die Wandöffnung (81) hineinragen, als Kammfinger befestigt sind, mit der Wand (8) und vorzugsweise Massepotential der elektrischen Vorrichtung verbunden oder verbindbar sind, **dadurch gekennzeichnet, dass**
die wenigstens eine Befestigungsvorrichtung (4) eine Klemmvorrichtung (41) umfasst, in der die Ableitelemente (3) festgeklemmt sind, oder dass die Ableitelemente (3) durch eine Lötverbindung oder eine Schweissverbindung mit der Befestigungsvorrichtung (4) verbunden sind und dass die Länge der Ableitelemente (3) derart gewählt ist, dass die Wandöffnung (81) verschlossen ist und dass zwei Befestigungsvorrichtungen (4) vorgesehen sind, die auf einander gegenüberliegenden Seiten der Wandöffnung (81) derart angeordnet sind, dass die von jeder Befestigungsvorrichtung (4) gehaltenen Ableitelemente (3) gegeneinander ausgerichtet sind und sich die Ableitelemente (3) der beiden Befestigungsvorrichtungen (4) überlappen.

2. Kontaktierungsvorrichtung (1) nach Anspruch 1, **dadurch gekennzeichnet, dass** die wenigstens eine Befestigungsvorrichtung (4) an einem Rand der Wandöffnung (81) befestigt und einseitig mit den Ableitelementen (3) verbunden ist oder dass die wenigstens eine Befestigungsvorrichtung (4) innerhalb der Wandöffnung (81) angeordnet und beidseitig mit den Ableitelementen (3) verbunden ist.

3. Kontaktierungsvorrichtung (1) nach Anspruch 1 oder 2, **dadurch gekennzeichnet, dass** die Wandöffnung (81) zumindest annähernd rechteckförmig ausgebildet ist und dass vorzugsweise auf jeder Rechteckseite (811) je eine Befestigungsvorrichtung (4) derart angeordnet ist, dass die Ableitelemente (3) senkrecht zur zugehörigen Rechteckseite (811) ausgerichtet in die Wandöffnung (81) hinein ragen.

4. Kontaktierungsvorrichtung (1) nach einem der Ansprüche 1 - 3, **dadurch gekennzeichnet, dass** die Ableitelemente (3) an beiden Enden je von einer Befestigungsvorrichtung (4) gehalten sind, wobei die Länge der Ableitelemente (3) vorzugsweise länger gewählt ist als der Abstand der beiden Befestigungsvorrichtungen (4).

5. Kontaktierungsvorrichtung (1) nach einem der Ansprüche 1 - 4, **dadurch gekennzeichnet, dass** die Ableitelemente (3) Metalllitzen umfassen und/oder, dass die Ableitelemente (3) mit einer Dichte von 10 bis 100 Stück pro Quadratmillimeter vorgesehen sind.

6. Kontaktierungsvorrichtung (1) nach einem der Ansprüche 1 - 5, **dadurch gekennzeichnet, dass** die Ableitelemente (3) aus Kupfer, Messing, beschichteten Metalldrähten, Stahldrähten oder mit einer leitfähigen Beschichtung beschichteten Kunststoffborsten bestehen und/oder dass die Ableitelemente (3) elastisch und/oder plattenförmig und/oder kurvenförmig ausgebildet sind.

7. Kontaktierungsvorrichtung (1) nach einem der Ansprüche 1 - 6, **dadurch gekennzeichnet, dass** die Ableitelemente einen Durchmesser von 0.025 mm bis 0.25 mm, vorzugsweise 0.05 mm bis 0.15 mm, aufweisen.

8. Kontaktierungsvorrichtung (1) nach einem der Ansprüche 1-7, **dadurch gekennzeichnet, dass** die Ableitelemente (3) U-förmig ausgeführt sind und zwei vorzugsweise gleich lange Schenkel aufweisen, die zumindest annähernd parallel zueinander ausgerichtet sind.

9. Kontaktierungsvorrichtung (1) nach einem der Ansprüche 1-8, **dadurch gekennzeichnet, dass** die Befestigungsvorrichtung (4) aus Blech oder Aluminium gefertigt ist.

10. Kontaktierungsvorrichtung (1) nach einem der Ansprüche 1 - 9, **dadurch gekennzeichnet, dass** eine Anschlussplatte mit Öffnungen oder eine Kabeldurchführung (6) vorgesehen ist, die dem mechanischen Halten und/oder der Abdichtung der durchgeführten Kabel (9) dient und die durch Verbindungsmittel (7) vorzugsweise parallel zu den Ableitelementen (3) ausgerichtet mit der Wand (8) verbunden ist.

11. Kabeldurchführung (10) mit einer Kontaktierungsvorrichtung (1) nach einem der Ansprüche 1 - 10.

12. Kabeldurchführung (10) nach Anspruch 11, **dadurch gekennzeichnet, dass** eine Anschlussplatte mit Öffnungen oder eine dem mechanischen Halten und/oder der Abdichtung der durchgeführten Kabel (9) dienende erste Kabeldurchführung (6) vorgesehen ist, die durch Verbindungsmittel (7) vorzugsweise parallel zu den Ableitelementen (3) ausgerichtet mit der Kontaktierungsvorrichtung (1), vorzugsweise mit der Wand (8) der Kontaktierungsvorrichtung (1) verbunden ist, die als kontaktierende zweite Kabeldurchführung dient.

## Claims

1. Contacting device (1) for a cable bushing, which is used in electrical devices, such as control cabinets, for the passage of cables (9), in particular shielded cables, with a wall (8) provided with a wall opening (81) and metal diverter elements (3) which are electrical Conductively connected or connectable on the one hand to the cable shield (91) of at least one cable (9) passed through the wall opening (81) and on the other hand via at least one fastening device (4), which is design as a metallic comb, in which the diverter elements (3) that are pointing wire-like into the wall opening (81) are fixe das comb fingers, to the wall (8) and preferably ground potential of the electrical device, **characterized in that** the fastening device (4) comprises a clamping device (41) in which the diverter elements (3) are clamped, or that the diverter elements (3) by a soldered connection or a Welded connection are connected to the fastening device (4) and that the length of the diverter elements (3) is selected such that the wall opening (81) is closed and that two fastening devices (4) are provided which are arranged on opposite sides of the wall opening (81) in such a way that the diverter elements (3) held by each fastening device (4) are aligned with each other and that the diverter elements (3) of the two fastening devices (4) overlap.

2. Contacting device (1) according to claim 1, **characterized in that** the at least one fastening device (4) is fastened to an edge of the wall opening (81) and is connected on one side to the diverter elements (3) or that the at least one fastening device (4) is inside the wall opening (81) and is connected on both sides to the diverter elements (3).

3. Contacting device (1) according to claim 1 or 2, **characterized in that** the wall opening (81) is at least approximately rectangular and that a fastening device (4) is preferably arranged on each side of the rectangle (811) such that the diverter elements (3) are vertical protrude into the wall opening (81) aligned with the associated rectangle side (811).

4. Contacting device (1) according to one of claims 1 - 3, **characterized in that** the diverter elements (3) are each held by a fastening device (4) at both ends, the length of the diverter elements (3) preferably being selected to be longer than the distance between the two fastening devices (4) .

5. Contacting device (1) according to one of claims 1 - 4, **characterized in that** the diverter elements (3) comprise metal strands and / or that the discharge elements (3) are provided with a density of 10 to 100 pieces per square millimetre.

6. Contacting device (1) according to one of claims 1 - 5, **characterized in that** the diverter elements (3) consist of copper, brass, coated metal wires, steel wires or plastic bristles coated with a conductive coating and / or that the conductor elements (3) are elastic and / or are plate-shaped and / or curved.

7. Contacting device (1) according to one of claims 1 - 6, **characterized in that** diverter elements (3) have a diameter of 0.025 mm to 0.25 mm, preferably 0.05 mm to 0.15 mm.

8. Contacting device (1) according to one of claims 1 - 7, **characterized in that** the diverter elements (3) are U-shaped and have two legs of preferably the same length, which are aligned at least approximately parallel to one another.

9. Contacting device (1) according to one of claims 1 - 8, **characterized in that** the fastening device (4) is made of sheet metal or aluminium.

10. Contacting device (1) according to one of claims 1 - 9, **characterized in that** connection plate with openings or a cable bushing (6) is provided, which serves to mechanically hold and / or seal the cables (9) and which is connected by connecting means (7) is connected to the wall (8), preferably aligned parallel to the diverter elements (3).

11. Cable bushing (10) with a contacting device (1) according to one of claims 1 - 10.

12. Cable bushing (10) according to claim 11, **characterized in that** a connection plate with openings or a first cable bushing (6) serving to mechanically hold and / or seal the lead-through cables (9) is provided, which preferably by means of connecting means (7) parallel to the diverter elements (3) are aligned with the contacting device (1), preferably connected to the wall (8) of the contacting device (1), which serves as a contacting second cable bushing.

## Revendications

1. Dispositif de contact (1) pour une traversée de câbles, utilisé dans des appareils électriques, tels que des armoires de commande, pour le passage de câbles (9), en particulier des câbles blindés, avec une paroi (8) pourvue d'une ouverture murale (81) et des éléments conducteurs métalliques (3) qui sont électriques connecté ou connectable de manière conductrice d'une part à la gaine de câble (91) d'au moins un câble (9) traversant l'ouverture murale (81) et d'autre part via au moins un dispositif de fixation (4), conçu en forme de peigne métallique, auquel les éléments conducteurs (3) sont attachés, à la paroi (8) et de préférence au potentiel de masse de l'appareil électrique, **caractérisé en ce que** le dispositif de fixation (4) comprend un dispositif de serrage (41) dans lequel les éléments conducteurs (3) sont serrés, ou que les éléments de déviation (3) par une connexion soudée ou un Les connexions soudées sont connectées au dispositif de fixation (4) et que la longueur des éléments conducteurs (3) est choisie de telle sorte que l'ouverture de paroi (81) est fermée et que deux dispositifs de fixation (4) sont prévus qui sont disposés sur les côtés opposés de l'ouverture de paroi (81) de telle sorte que les éléments conducteurs (3) maintenus par chaque dispositif de fixation (4) sont alignés les uns avec les autres.

2. Dispositif de contact (1) selon la revendication 1, **caractérisé en ce que** le au moins un dispositif de fixation (4) est fixé à un bord de l'ouverture de paroi (81) et est relié d'un côté aux éléments conducteurs (3) ou que le au moins un dispositif de fixation (4) est à l'intérieur de l'ouverture de paroi (81) et est connecté des deux côtés aux éléments conducteurs (3).

3. Dispositif de contact (1) selon la revendication 1 ou 2, **caractérisé en ce que** l'ouverture de paroi (81) est au moins approximativement rectangulaire et qu'un dispositif de fixation (4) est de préférence disposé de chaque côté du rectangle (811) de sorte que les éléments conducteurs (3) soient verticaux dans l'ouverture de paroi (81) alignée avec le côté rectangle associé (811).

4. Dispositif de contact (1) selon l'une des revendications 1 - 3, **caractérisé en ce que** les éléments conducteurs (3) sont chacun maintenus par un dispositif de fixation (4) aux deux extrémités, la longueur des éléments conducteurs (3) étant de préférence choisie pour être plus longue que la distance entre les deux dispositifs de fixation (4).

5. Dispositif de contact (1) selon l'une des revendications 1 - 4, **caractérisé en ce que** les éléments conducteurs (3) comprennent des brins métalliques et / ou que les éléments conducteurs (3) sont pourvus d'une densité de 10 à 100 pièces par millimètre carré.

6. Dispositif de contact (1) selon l'une des revendications 1 - 5, **caractérisé en ce que** les éléments conducteurs (3) sont formés de cuivre, de laiton, de fils métalliques revêtus, de fils d'acier ou de poils en plastique revêtus d'un revêtement conducteur et / ou que les éléments conducteurs (3) sont élastiques et / ou sont en forme de plaque et / ou incurvées.

7. Dispositif de contact (1) selon l'une des revendications 1 - 6, **caractérisé en ce que** les éléments conducteurs (3) ont un diamètre de 0,025 mm à 0,25 mm, de préférence de 0,05 mm à 0,15 mm.

8. Dispositif de contact (1) selon l'une des revendications 1 - 7, **caractérisé en ce que** les éléments conducteurs (3) sont en forme de U et ont deux jambes de préférence de la même longueur, qui sont alignées au moins approximativement parallèlement l'une à l'autre.

9. Dispositif de contact (1) selon l'une des revendications 1 - 8, **caractérisé en ce que** le dispositif de fixation (4) est réalisé en tôle ou en aluminium.

10. Dispositif de contact (1) selon l'une des revendications 1 - 9, **caractérisé en ce qu'**une plaque de connexion avec des ouvertures ou un passage de câble (6) est prévue, qui sert à maintenir et / ou à sceller mécaniquement les câbles (9) et qui est reliée par des moyens de connexion (7) est reliée à la paroi (8), de préférence alignée parallèlement aux éléments déviateurs (3).

11. Traversée de câble (10) avec un dispositif de contact (1) selon l'une des revendications1 - 10.

12. Traversée de câble (10) selon la revendication 11, **caractérisée en ce qu'**une plaque de connexion avec des ouvertures ou une première traversée de câble (6) servant à maintenir et / ou à sceller mécaniquement les câbles de traversée (9) est prévue, qui de préférence au moyen de moyens de connexion (7) parallèles à les éléments de décharge (3) sont alignés avec le dispositif de contact (1), de préférence connectés à la paroi (8) du dispositif de contact (1), qui sert de seconde traversée de câble de contact.
